# EUROPÄISCHE PATENTSCHRIFT

(11) **EP 2 122 697 B1**
(45) Veröffentlichungstag und Bekanntmachung des Hinweises auf die Patenterteilung: **04.07.2018**
(21) Anmeldenummer: 08706837.5
(22) Anmeldetag: 31.01.2008
(51) Int. Cl.: H01L 33/42, H01L 33/38, H01L 27/15, H01L 25/075, H01L 33/62

(54) **STRAHLUNG EMITTIERENDER HALBLEITERKÖRPER MIT EINER FÜR DIE EMITTIERTE STRAHLUNG DURCHLÄSSIGEN, ELEKTRISCH LEITENDEN KONTAKTSCHICHT**
RADIATION EMITTING SEMI-CONDUCTOR BODY HAVING AN ELECTRICALLY CONDUCTIVE CONTACT LAYER PERMEABLE TO THE EMITTED RADIATION
CORPS À SEMI-CONDUCTEURS ÉMETTANT UN RAYONNEMENT COMPORTANT UNE COUCHE DE CONTACT ÉLECTROCONDUCTRICE PERMÉABLE AU RAYONNEMENT ÉMIS

(30) Priorität: 21.02.2007 DE 102007008524
(43) Veröffentlichungstag der Anmeldung: 25.11.2009
(73) Patentinhaber: OSRAM Opto Semiconductors GmbH, 93055 Regensburg (DE)
(72) Erfinder: WIRTH, Ralph, 93098 Mintraching (DE)
(74) Vertreter: Epping - Hermann - Fischer
(86) Internationale Anmeldenummer: PCT/DE2008/000172
(87) Internationale Veröffentlichungsnummer: WO 2008/101456

(56) Entgegenhaltungen:
- WO-A-2005/015647
- WO-A-2005/099310
- JP-A- 63 244 689
- JP-A- 2006 237 071
- US-A1- 2004 031 967
- US-A1- 2006 002 442
- US-A1- 2007 023 765

## Beschreibung

Die Erfindung betrifft einen Chip, der zur Emission von Strahlung vorgesehen ist. Insbesondere weist der Chip auf einer strahlungsaustrittsseitigen Oberfläche eine drahtlose Kontaktierung auf.

Optoelektronische Bauelemente der genannten Art, wie zum Beispiel lichtemittierende Dioden (LEDs), weisen in der Regel zwei gegenüberliegende Kontaktflächen auf, wobei oftmals eine der Kontaktflächen auf einen elektrisch leitfähigen Träger, beispielsweise auf einen mit einer Metallisierungsschicht versehenen Bereich eines Chipgehäuses, montiert wird.

Die elektrische Kontaktierung der weiteren Kontaktfläche wird herkömmlicherweise mit einem Bonddraht hergestellt. Zur Herstellung einer elektrisch leitenden Verbindung zwischen dem Bonddraht und der zur kontaktierenden Chipoberfläche wird ein Bereich der Chipoberfläche mit einer metallischen Schicht, dem sogenannten Bondpad versehen. Diese Metallschicht hat aber den Nachteil, dass sie optisch nicht transparent ist und dadurch ein Teil des im Chip generierten Lichts absorbiert wird. Eine Reduzierung der Fläche des Bondpads ist jedoch technisch nur beschränkt möglich und erhöht den Herstellungsaufwand.

Um das Problem der Abschattung eines Teils der zur Strahlungsauskopplung vorgesehenen Oberfläche eines optoelektronischen Bauelements zu vermindern, ist aus der JP 09283801 A bekannt, eine auf der Oberfläche des Halbleiterchips angeordnete Elektrode mit einer elektrisch leitfähigen transparenten Schicht aus Indium-Zinn-Oxid (ITO) drahtlos zu kontaktieren. Die Seitenflanken des Halbleiterchips werden dabei durch eine isolierende Schicht aus SiO₂ von der leitfähigen transparenten Schicht elektrisch isoliert.

US 2007/023765 A1 (THOMAS ALAN C [US] ET AL; 1. Februar 2007) beschreibt eine Anordnung gemäß dem Oberbegriff des Anspruchs 1.

Der Erfindung liegt die Aufgabe zugrunde, einen Chip anzugeben, bei welchem das Problem der Abschattung einer auf der Strahlungsaustrittsseite des Chips angeordneten Oberfläche eines Halbleiterkörpers weiter verringert ist. Diese Aufgabe wird durch einen Chip nach Patentanspruch 1 gelöst. Vorteilhafte Ausgestaltungen und Weiterbildungen der Erfindung sind Gegenstand der abhängigen Ansprüche. Dabei bezeichnen in der folgenden Beschreibung die Begriffe "Ausgestaltung", "Ausführungsbeispiel" und "Ausführungsform" nur dann Ausführungsbeispiele der vorliegenden Erfindung, wenn sie jeweils alle im Anspruch 1 definierten Merkmale enthalten. Ansonsten bezeichnen diese Begriffe lediglich andere Beispiele, die für das Verstehen der vorliegenden in Anspruch 1 definierten Erfindung hilfreich sind.

Ein erfindungsgemäßer Chip umfasst mindestens einen Halbleiterkörper, der einen Strahlung emittierenden Bereich aufweist, und weiterhin mindestens einen ersten Kontaktbereich, der zur elektrischen Kontaktierung des Halbleiterkörpers vorgesehen ist und vom Strahlung emittierenden Bereich lateral beabstandet ist, und außerdem eine für die emittierte Strahlung durchlässige, elektrisch leitende erste Kontaktschicht, welche eine Oberfläche des Halbleiterkörpers, die sich auf der Strahlungsaustrittsseite des Chips befindet, mit dem ersten Kontaktbereich verbindet, wobei die Oberfläche frei ist von die Strahlung absorbierenden Kontaktstrukturen.

Vorzugsweise ist die erste Kontaktschicht auf der Strahlungsaustrittsseite frei von die Strahlung absorbierenden Kontaktstrukturen.

Vorliegend sind unter Kontaktstrukturen insbesondere metallische Kontaktbereiche zum Beispiel in Form von Kontaktstegen oder Bondpads zu verstehen. Demnach ist die erste Kontaktschicht keine Kontaktstruktur. Mangels Strahlung absorbierender Kontaktstrukturen auf der Strahlungsaustrittsseite des Chips ist die durch den Chip mögliche Strahlungsemission vorteilhaft erhöht. Ferner kann auf der strahlungsaustrittsseitigen Oberfläche mit Vorteil auf einen abschattenden Bonddraht verzichtet werden, der typischerweise ein auf der strahlungsaustrittsseitigen Oberfläche angeordnetes Bondpad mit einem Anschlussbereich verbindet. Dies ist dadurch möglich, dass die erste Kontaktschicht sowohl das Bondpad als auch den Bonddraht ersetzt. Selbstverständlich ist bei der vorliegenden Erfindung ein elektrischer Anschluss des Chips mittels einer Drahtverbindung nicht ausgeschlossen. Der erste Kontaktbereich kann beispielsweise mittels eines Bonddrahtes mit einer Spannungsquelle elektrisch verbunden sein.

Der Strahlung emittierende Bereich umfasst einen strahlungserzeugenden pn-Übergang. Dieser pn-Übergang kann im einfachsten Fall mittels einer p-leitenden und einer n-leitenden Halbleiterschicht gebildet sein, die unmittelbar aneinandergrenzen. Bevorzugt ist zwischen der p-leitenden und der n-leitenden aktiven Schicht die eigentliche strahlungserzeugende Schicht, etwa in Form einer dotierten oder undotierten Quantenschicht, ausgebildet. Die Quantenschicht kann als Einfachquantentopfstuktur (SQW, Single Quantum Well) oder Mehrfachquantentopfstruktur (MQW, Multiple Quantum Well) oder auch als Quantendraht oder Quantenpunktstruktur ausgeformt sein.

Bei einer bevorzugten Ausgestaltung des Chips ist der erste Kontaktbereich vom Strahlung emittierenden Bereich räumlich getrennt. Insbesondere erstrecken sich weder der Strahlung emittierende Bereich noch sonstige Halbleiterschichten bis zum ersten Kontaktbereich. Sollte dies doch der Fall sein, so sind die Halbleiterschichten am Übergang zum ersten Kontaktbereich vorzugsweise durchtrennt, beispielsweise durch eine Trennfuge, um die Erzeugung von Stahlung direkt unter dem ersten Kontaktbereich, der strahlungsabsorbierend sein kann, zu verhindern.

Da der erste Kontaktbereich nicht im Hauptstrahlengang des Chips angeordnet ist, kann der erste Kontaktbereich ohne besondere Berücksichtigung optischer Eigenschaften und somit hauptsächlich unter dem Aspekt der vergleichsweise guten elektrischen Leitfähigkeit beziehungsweise Stromverteilung ausgebildet werden. Vorteilhafterweise kann bei dem erfindungsgemäßen Chip eine verbesserte Strahlungsemission bei gleichzeitig verbesserter elektrischer Kontaktierung erzielt werden.

Gemäß einer bevorzugten Ausführungsform ist die Oberfläche größtenteils von der ersten Kontaktschicht bedeckt. Dies bedeutet, dass die Oberfläche vollständig oder nahezu vollständig von der ersten Kontaktschicht bedeckt ist, wobei im Falle einer nahezu vollständigen Bedeckung insbesondere eine Isolierschicht vorgesehen sein kann, die beispielsweise auf der Oberfläche randseitig und gegebenenfalls umfangsseitig angeordnet ist.

Gemäß einer besonders bevorzugten Ausführungsform bildet die erste Kontaktschicht eine den Chip in einer Hauptabstrahlrichtung nach außen begrenzende Schicht. Vorzugsweise enthält die erste Kontaktschicht ein TCO (Transparent Conductive Oxide). Das TCO kann beispielsweise auf den Halbleiterkörper aufgesputtert oder aufgedampft werden. TCOs sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Dies ist insbesondere vorliegend der Fall, wenn sowohl für die erste Kontaktschicht mit einer ersten Leitfähigkeit und für eine zweite Kontaktschicht mit einer zweiten Leitfähigkeit ein TCO verwendet wird. Beispielsweise kann das TCO der ersten Kontaktschicht p-dotiert sein, während das TCO der zweiten Kontaktschicht n-dotiert ist.

Gemäß einer bevorzugten Weiterbildung ist der erste Kontaktbereich ein Bondpad oder Kontaktfinger. Besonders bevorzugt enthält der erste Kontaktbereich ein Metall, etwa Au. Vorteilhafterweise weist der erste Kontaktbereich einen vergleichsweise hohen Reflexionsgrad auf, der insbesondere 90% betragen kann. Im Vergleich zu einem herkömmlichen Chip, bei welchem Lichtstrahlen, die nahe einem Bondpad starten, mit einer Wahrscheinlichkeit von etwa 50% absorbiert werden, sind die durch den ersten Kontaktbereich verursachten Strahlungsverluste relativ gering. Der vergleichsweise hohe Reflexionsgrad kann in Summe durch die Beabstandung des ersten Kontaktbereichs vom Halbleiterkörper, durch eine geeignete Wahl des Materials und die Form des ersten Kontaktbereichs, beispielsweise prismenartig, erreicht werden.

Gemäß einer besonders bevorzugten Weiterbildung sind der erste Kontaktbereich und der Halbleiterkörper auf einem gemeinsamen Träger angeordnet. Mittels des Trägers ist die Stabilität des Chips vorteilhaft erhöht, was beispielsweise eine Handhabung des Chips erleichtert. Gemäß der vorliegenden Erfindung weist der Chip eine zweite Kontaktschicht auf, die den Halbleiterkörper mit einem zweiten Kontaktbereich zur elektrischen Kontaktierung des Halbleiterkörpers verbindet. Die zweite Kontaktschicht ermöglicht ebenfalls eine drahtlose Kontaktierung des Halbleiterkörpers. Der Halbleiterkörper kann mittels eines elektrisch leitfähigen Klebstoffs sowohl mechanisch als auch elektrisch mit dem zweiten Kontaktbereich verbunden sein. Bevorzugterweise ist der zweite Kontaktbereich auf den Träger aufgebracht. Besonders bevorzugt wird der zweite Kontaktbereich auf dem Träger ausgebildet, bevor der mindestens eine Halbleiterkörper auf dem Träger montiert wird. Zweckmäßigerweise ist der zweite Kontaktbereich metallisch ausgebildet. Insbesondere kann der zweite Kontaktbereich Au, Al, Ag, AuZn enthalten. Derartige Materialien eignen sich u.a. für eine Ausbildung des zweiten Kontaktbereichs als Reflexionsschicht.

Gemäß einer bevorzugten Ausführungsform ist der zweite Kontaktbereich eine Reflexionsschicht, die geeignet ist, die auftreffende Strahlung in Richtung der Hauptabstrahlrichtung zu emittieren. Die vom Chip emittierte Strahlung kann somit vorteilhaft erhöht werden.

Gemäß einer weiter bevorzugten Ausführungsform ist der erste Kontaktbereich dem zweiten Kontaktbereich ausgehend vom Träger in vertikaler Richtung nachgeordnet.

Die Hauptabstrahlrichtung und die vertikale Richtung bezeichnen vorliegend beide eine parallel zu einer Wachstumsrichtung verlaufende Richtung, in welcher die Halbleiterschichten des Halbleiterkörpers aufgewachsen sind.

Vorzugsweise ist die zweite Kontaktschicht zwischen dem Halbleiterkörper und dem zweiten Kontaktbereich angeordnet und bildet zusammen mit dem zweiten Kontaktbereich einen Spiegel. Insbesondere kann die zweite Kontaktschicht für die emittierte Strahlung durchlässig sein. Strahlung, die durch die zweite Kontaktschicht transmittiert wird, kann dann an der Reflexionsschicht reflektiert werden. Beipsielsweise kann die zweite Kontaktschicht ein TCO enthalten. Bei Verwendung des gleichen Materials für die erste und die zweite Kontaktschicht kann der Halbleiterkörper vollständig in dieses Material, insbesondere TCO, eingebettet sein.

Um einen Kurzschluss zu verhindern, kann zwischen dem ersten Kontaktbereich und dem zweiten Kontaktbereich eine Isolierschicht angeordnet sein. Zusätzlich ist die Isolierschicht vorzugsweise derart angeordnet, dass ein Kurzschluss zwischen p-leitenden und n-leitenden Bereichen des Halbleiterkörpers verhindert wird. In diesem Fall kann ein Teil der Isolierschicht auf Seitenflächen des Halbleiterkörpers aufgebracht sein. Geeignete Materialien für die Isolierschicht sind zum Beispiel Siliziumnitrid oder Siliziumoxid.

Bei einer Variante, die nicht Bestandteil der vorliegenden Erfindung ist, weist der Chip mindestens einen ersten und einen zweiten Halbleiterkörper auf, die lateral beabstandet sind und zwischen welchen ein erster Kontaktbereich angeordnet ist. Diese Anordnung ist insbesondere bei größeren Chips, vorzugsweise mit einer Kantenlänge größer als etwa 400µm, vorteilhaft, da hierbei mittels in Form eines Kontaktgitters angeordneter erster Kontaktbereiche eine ausreichende Stromverteilung möglich ist. Gemäß der vorliegenden Erfindung weist der Chip einen Halbleiterkörper mit einem zentralen Durchbruch auf, in welchem der erste Kontaktbereich angeordnet ist. Diese Ausbildung ist insbesondere für kleinere Chips, vorzugsweise mit einer Kantenlänge bis zu etwa 400µm, geeignet.

Gemäß einer bevorzugten Ausführungsform ist der Chip ein Dünnfilm-Leuchtdioden-Chip. Ein Dünnfilm-Leuchtdioden-Chip zeichnet sich insbesondere durch mindestens eines der folgenden Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 1µm bis 2µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben. Ein Dünnfilm-Leuchtdioden-Chip ist in guter Näherung ein Lambert'scher Oberflächenstrahler und eignet sich von daher besonders gut für die Anwendung in einem Scheinwerfer.

Der Halbleiterkörper kann auf Phosphid-Verbindungshalbleitern basierende Schichten aufweisen.
"Auf Phosphid-Verbindungshalbleitern basierend" bedeutet in diesem Zusammenhang, dass ein derart bezeichnetes Bauelement oder Teil eines Bauelements vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Alternativ kann der Halbleiterkörper auf Nitrid-Verbindungshalbleitern basierende Schichten aufweisen.

"Auf Nitrid-Verbindungshalbleitern basierend" bedeutet im vorliegenden Zusammenhang, dass die aktive EpitaxieSchichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Die Epitaxieschichtenfolge des Dünnfilm-Leuchtdioden-Chips kann insbesondere bei Verwendung eines auf Nitrid-Verbindungshalbleitern basierenden Materials eine Dicke aufweisen, die geringer ist als 1*µ*m.

Vorteilhafterweise wird bei dem vorliegend beschriebenen Chip keine Stromaufweitungsschicht im Halbleiterkörper benötigt. Denn mittels der ersten Kontaktschicht ist eine ausreichende Stromaufweitung möglich. Daher kann die Epitaxieschichtenfolge mit einer Dicke von höchstens 2µ*m* ausgebildet werden.

Weitere Verbesserungen der Strahlungsintensität des Chips können dadurch erzielt werden, dass die auf der Strahlungsaustrittsseite angeordnete Oberfläche des Halbleiterkörpers Auskoppelelemente aufweist. Beispielsweise kann die Oberfläche aufgeraut sein, Mikroprismen oder einen photonischen Kristall aufweisen.

Die Erfindung wird im folgenden anhand von fünf Ausführungsbeispielen im Zusammenhang mit den Figuren 1 bis 5 näher erläutert.

Es zeigen:
Figur 1 eine schematische Darstellung eines Querschnitts durch ein erstes Ausführungsbeispiel eines Chips,
Figur 2 eine schematische Darstellung eines Querschnitts durch ein zweites Ausführungsbeispiel eines Chips,
Figur 3 eine schematische Darstellung eines Querschnitts durch ein drittes Ausführungsbeispiel eines Chips,
Figur 4 eine schematische Darstellung eines Querschnitts durch ein viertes Ausführungsbeispiel eines Chips, und
Figur 5 eine schematische Darstellung eines Querschnitts durch ein Ausführungsbeispiel eines Chips gemäß der Erfindung.

Gleiche oder gleichwirkende Elemente sind in den Figuren mit den gleichen Bezugszeichen versehen.

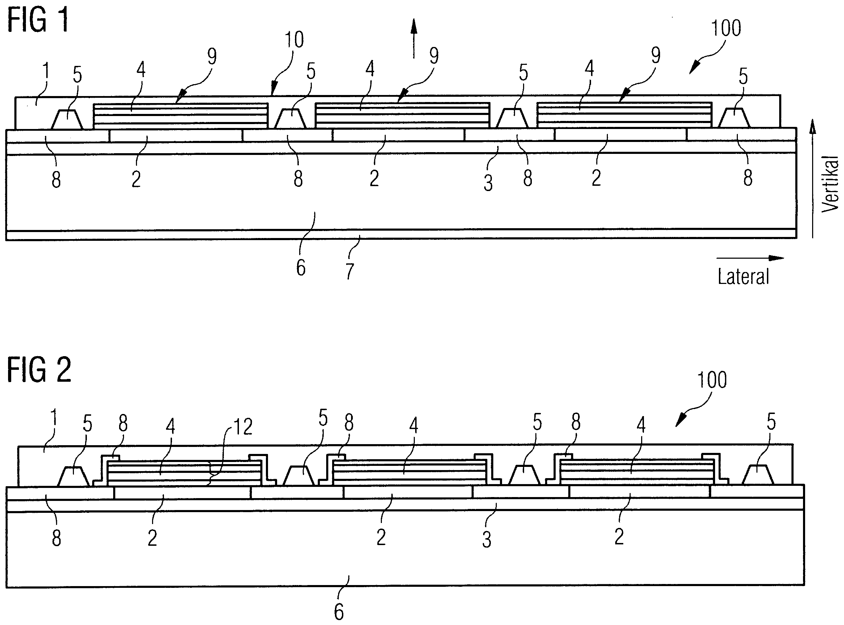

Die schematische Darstellung in Figur 1 zeigt einen Querschnitt durch einen Chip 100, wobei die Schnittfläche parallel zu einer Seitenfläche des Chips 100 verläuft. Der Chip 100 umfasst separate Halbleiterkörper 4, die auf einem Träger 6 regelmäßig angeordnet sind. Vorzugsweise bilden die Halbleiterkörper 4 ein Matrixmuster, das in diesem Fall aus drei Zeilen und drei Spalten besteht. Eine Unterteilung in mehrere Halbleiterkörper ist insbesondere bei größeren Chips angebracht, die eine Kantenlänge vorzugsweise größer als etwa 400µm aufweisen. Denn bei dieser Ausgestaltung ist mittels einer Mehrzahl von ersten Kontaktbereichen 5 eine vorteilhaft homogene Stromverteilung im Chip 100 möglich.

Jeder Halbleiterkörper 4 ist zwischen zwei ersten Kontaktbereichen 5 angeordnet. Insbesondere sind die ersten Kontaktbereiche 5 Kontaktfinger, die sich linienartig entlang der Spalten und Zeilen erstrecken, in welchen die Halbleiterkörper 4 angeordnet sind. So bilden die ersten Kontaktbereiche 5 ein Kontaktgitter, das für eine vorteilhafte Stromverteilung im Chip 100 sorgt. Die ersten Kontaktbereiche 5 sind vorzugsweise metallisch ausgebildet, wobei ein Metall mit vorteilhafter elektrischer Leitfähigkeit und vorteilhaftem Reflexionsgrad, beispielsweise Au, geeignet ist. Neben der elektrischen Versorgung sind die ersten Kontaktbereiche 5 zur Reflexion von auftreffender Strahlung geeignet. Insbesondere wird die auftreffende Strahlung in eine Haupstrahlrichtung umgelenkt, die in Figur 1 durch einen Pfeil angezeigt ist. Dies kann durch schräg verlaufende Seitenflächen der ersten Kontaktbereiche 5 erreicht werden. Wie Figur 1 zeigt, kann die Querschnittsform der ersten Kontaktbereiche 5 ein Trapez sein.

Die Halbleiterkörper 4 und die ersten Kontaktbereiche 5 sind in eine erste Kontaktschicht 1 eingebettet. Die erste Kontaktschicht 1 ist elektrisch leitend und für die von den aktiven Bereichen der Halbleiterkörper 4 emittierte Strahlung durchlässig. Für die erste Kontaktschicht 1 geeignete Materialien sind beispielsweise TCOs. Da die erste Kontaktschicht 1 eine Oberfläche 9 der Halbleiterkörper 4, die sich auf einer Strahlungsaustrittsseite 10 des Chips 100 befindet, vollständig bedeckt und sich außerdem keine die Strahlung absorbierenden Kontaktstrukturen auf der Oberfläche 9 befinden, sind die Halbleiterkörper 4 ohne Abschattung der Oberfläche 9 elektrisch angeschlossen. Obwohl Seitenflächen der Halbleiterkörper 4 von der ersten Kontaktschicht 1 bedeckt sind, ist kein Kurzschluss zu befürchten, da der seitliche Kontakt hinreichend schlecht ist für einen Betrieb der Halbleiterkörper 4.

Die ersten Kontaktbereiche 5 sind auf einer Isolierschicht 8 angeordnet, welche die ersten Kontaktbereiche 5 von einem zweiten Kontaktbereich 3 elektrisch isoliert. Ferner ist die erste Kontaktschicht 1 mittels der Isolierschicht 8 von einer zweiten Kontaktschicht 2 elektrisch isoliert. Die Isolierschicht 8 enthält beispielsweise Siliziumnitrid oder Siliziumoxid und ist beim vorliegenden Ausführungsbeispiel derart strukturiert, dass Bereiche zwischen den Halbleiterkörpern 4 und dem zweiten Kontaktbereich 3 im Wesentlichen frei sind von der Isolierschicht 8. In diesen Bereichen ist die zweite Kontaktschicht 2 angeordnet, mittels welcher die Halbleiterkörper 4 mit dem zweiten Kontaktbereich 3 elektrisch und mechanisch verbunden sind. Bevorzugterweise ist die zweite Kontaktschicht 2 für die vom Halbleiterkörper 4 erzeugte Strahlung durchlässig und enthält besonders bevorzugt ein TCO. Mit dieser Eigenschaft bildet die Kontaktschicht 2 zusammen mit dem zweiten Kontaktbereich 3 insbesondere einen Spiegel, so dass die auftreffende Strahlung mit großer Wahrscheinlichkeit in Hauptabstrahlrichtung reflektiert wird.

Der zweite Kontaktbereich 3 bedeckt eine den Halbleiterkörpern 4 zugewandte Oberfläche des Trägers 6 vollständig. Vorzugsweise enthält der zweite Kontaktbereich 3 ein Metall oder eine Metallverbindung, beispielsweise Au, Al, Ag oder AuZn.

Im dargestellten Fall ist der Chip 100 mittels eines Rückseitenkontakts 7 elektrisch anschließbar. Der Träger 6 enthält hierbei ein elektrisch leitendes Material, etwa ein Metall oder einen Halbleiter.

Die Halbleiterkörper 4 sind Dünnfilm-Halbleiterkörper, bei welchen das Aufwachssubstrat vollständig oder bis auf wenige Reste abgelöst ist. Somit weisen die Halbleiterkörper 4 einen Strahlung emittierenden Bereich sowie n-leitende und p-leitende Mantelschichten auf, die Teil einer Epitaxieschichtenfolge 12 sind beziehungsweise die Epitaxieschichtenfolge 12 bilden. Die Dicke der Epitaxieschichtenfolge 12 beträgt höchstens 2*µ*m, wobei die Dicke derart gering gehalten werden kann, weil aufgrund der ersten Kontaktschicht 1 eine Stromaufweitungsschicht im Halbleiterkörper 4 nicht gebraucht wird.

Bei dem in Figur 2 dargestellten Chip 100 sind die Halbleiterkörper 4 in TCO eingebettet. Die erste Kontaktschicht 1 und die zweite Kontaktschicht 2, welche zusammen die Halbleiterkörper 4 einschließen, sind durch die Isolierschicht 8 voneinander elektrisch isoliert.

In diesem Ausführungsbeispiel sind die Seitenflächen der Halbleiterkörper 4 nicht von der Kontaktschicht 1, sondern von der Isolierschicht 8 bedeckt. Vorteilhafterweise ist somit der seitliche Kontakt unterbrochen.

Die Halbleiterkörper 4 sind auf dem Träger 6 angeordnet, der elektrisch nicht leitend ist. Beispielsweise kann der Träger 6 ein Keramikmaterial mit vergleichsweise hoher Wärmeleitfähigkeit zur Kühlung des Chips 100 enthalten. Trägerseitig ist der elektrische Anschluss dann nicht mittels eines Rückseitenkontakts realisiert, sondern vorzugsweise mittels eines elektrisch leitenden Kontaktfingers, der in der gleichen Ebene wie der zweite Kontaktbereich 3 angeordnet und mit diesem elektrisch verbunden ist.

Auf den ersten Kontaktbereich 5 und den mit dem zweiten Kontaktbereich 3 verbundenen Kontaktfinger kann jeweils ein Bonddraht gebondet werden, wobei die Bonddrähte an verschiedene Pole einer Energieversorgung angeschlossen sind.

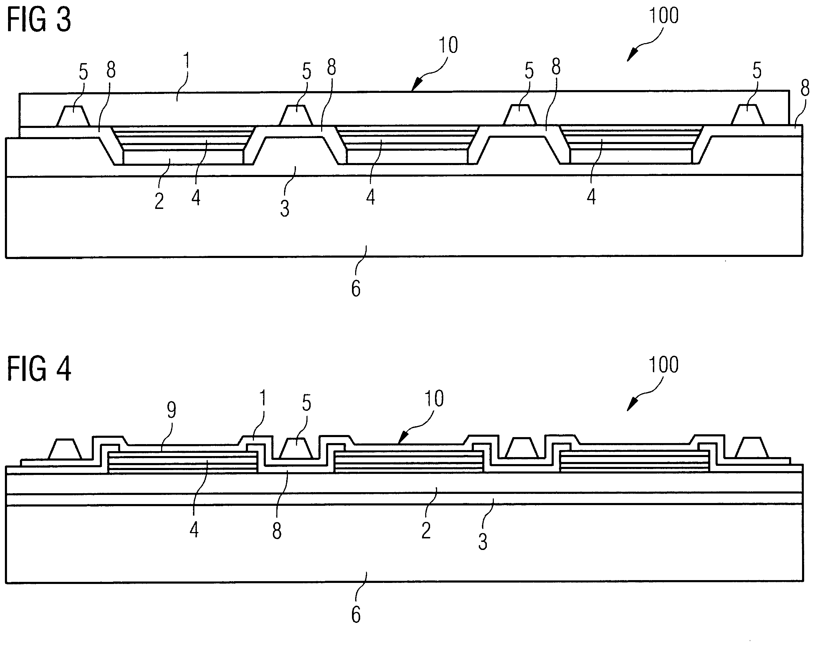

Während der zweite Kontaktbereich 3 in den Ausführungsbeispielen der Figuren 1 und 2 eine auf die Oberfläche des Trägers 6 aufgebrachte gleichmäßig dicke Schicht ist, weist der zweite Kontaktbereich 3 des in Figur 3 dargestellten Chips 100 Vertiefungen und Erhebungen auf. Die Seitenflächen der Erhebungen, die zugleich die Seitenflächen der Vertiefungen bilden, verlaufen schräg. Insbesondere sind die Erhebungen in Form von Mikroprismen ausgebildet, welche vorteilhafterweise die Strahlungsauskopplung verbessern. In die Vertiefungen sind die Halbleiterkörper 4 eingelassen, wobei ein direkter Kontakt zwischen den Halbleiterkörpern 4 und dem zweiten Kontaktbereich 3 durch die Isolierschicht 8 verhindert wird. Die Isolierschicht 8 überzieht die Erhebungen und lässt den Boden der Vertiefungen unbedeckt. Der Hohlraum, der hierdurch zwischen den Halbleiterkörpern 4 und dem zweiten Kontaktbereich 3 entsteht, ist durch die zweite Kontaktschicht 2 ausgefüllt.

In vertikaler Richtung sind die ersten Kontaktbereiche 5 den Erhebungen nachgeordnet. Die ersten Kontaktbereiche 5 sind in die erste Kontaktschicht 1 eingebettet, wobei die erste Kontaktschicht 1 eine den Chip 100 nach außen begrenzende Schicht ist.

Bei dem in Figur 4 dargestellten Ausführungsbeispiel sind sowohl der zweite Kontaktbereich 3 als auch die zweite Kontaktschicht 2 unstrukturierte Schichten. Im Gegensatz zu den in den Figuren 1 bis 3 dargestellten Ausführungsbeispielen ist somit der durch den zweiten Kontaktbereich 3 und die zweite Kontaktschicht 2 gebildete Spiegel ebenfalls unstrukturiert. Bei dieser Ausgestaltung ist der Herstellungsaufwand vorteilhaft verringert, weil der Strukturierungsschritt entfällt.

Die Halbleiterkörper 4 sind auf der gleichmäßig dicken zweiten Kontaktschicht 2 angeordnet. Die Isolierschicht 8 überzieht die zweite Kontaktschicht 2 und die Halbleiterkörper 4 und ist lediglich an der Oberfläche 9 unterbrochen, so dass eine nahezu vollständige Bedeckung der Oberfläche 9 durch die erste Kontaktschicht 1 möglich ist. In den zwischen den Halbleiterkörpen 4 vorhandenen Gräben und ebenso am Rand sind die ersten Kontaktbereiche 5 auf die erste Kontaktschicht 1 aufgebracht. Obwohl die erste Kontaktschicht 1 in diesem Ausführungsbeispiel keine Abdeckschicht bildet, weist der Chip 100 dennoch auf der Strahlungsaustrittsseite 10 keine hervorstehenden Elemente auf. Dies kann dadurch erreicht werden, dass die ersten Kontaktbereiche 5 in die Gräben versenkt sind.

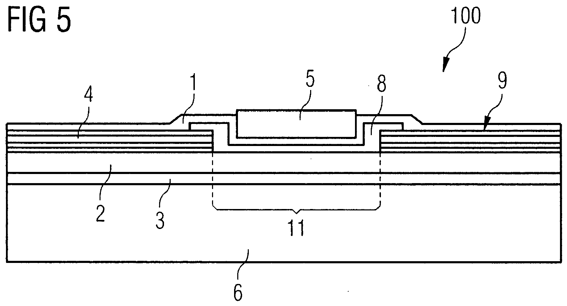

Figur 5 zeigt eine Variante eines Chips 100 gemäß der vorliegenden Erfindung, der sich durch seine Größe von den in den Figuren 1 bis 4 dargestellten Ausführungsbeispielen unterscheidet. Das Design ist für kleinere Chips, insbesondere mit einer Kantenlänge kleiner als 400µm, geeignet. Der Chip 100 umfasst einen einstückigen Halbleiterkörper 4, der einen Durchbruch 11 aufweist. Der Durchbruch 11 ist mit Vorteil zentral angeordnet, so dass mittels des innerhalb des Durchbruchs 11 angeordneten ersten Kontaktbereichs 5 eine isotrope Bestromung des Halbleiterkörpers 4 möglich ist. Unterhalb des ersten Kontaktbereichs 5 befinden sich, ebenso wie bei den vorausgehenden Ausführungsbeispielen, keine zur Strahlungsemission geeigneten Halbleiterschichten, so dass der erste Kontaktbereich 5 nicht im Haupstrahlengang des Chips 100 angeordnet ist und somit keine Abschattung auftritt. Darüberhinaus ist durch den ersten Kontaktbereich 5 keine wesentliche Strahlungsminderung zu befürchten, da mittels des Kontaktbereichs 5 ein auftreffender Lichtstrahl entweder in die Hauptabstrahlrichtung umgelekt oder in den Halbleiterkörper 4 zurückgeworfen wird, von wo der Lichtstrahl erneut ausgekoppelt werden kann.

Der Durchbruch 11 ist von der Isolierschicht 8 ausgekleidet, wobei sich die Isolierschicht 8 bis zur Oberfläche 9 des Halbleiterkörpers 4 erstreckt. Die Oberfläche 9 ist jedoch größtenteils von der ersten Kontaktschicht 1 bedeckt. Ferner bedeckt die erste Kontaktschicht 1 die Isolierschicht 8 und umhüllt einen unteren Teil des ersten Kontaktbereichs 5.

## Patentansprüche

1. Chip (100)
- mit mindestens einem Halbleiterkörper (4), der einen Strahlung emittierenden Bereich aufweist,
- mit mindestens einem ersten Kontaktbereich (5), der zur elektrischen Kontaktierung des Halbleiterkörpers (4) vorgesehen ist und vom Strahlung emittierenden Bereich lateral beabstandet ist, und
- mit einer für die emittierte Strahlung durchlässigen, elektrisch leitenden ersten Kontaktschicht (1), welche eine Oberfläche (9) des Halbleiterkörpers (4), die sich auf der Strahlungsaustrittsseite (10) des Chips (100) befindet, mit dem ersten Kontaktbereich (5) verbindet, wobei
- der Chip (100) eine zweite Kontaktschicht (2) aufweist, die den Halbleiterkörper (4) mit einem zweiten Kontaktbereich (3) zur elektrischen Kontaktierung des Halbleiterkörpers (4) verbindet, und
- der Halbleiterkörper (4) in vertikaler Richtung zwischen der ersten Kontaktschicht (1) und der zweiten Kontaktschicht (2) angeordnet ist, wobei die vertikale Richtung eine parallel zu einer Wachstumsrichtung verlaufende Richtung bezeichnet, in welcher Halbleiterschichten des Halbleiterkörpers (4) aufgewachsen sind,
**dadurch gekennzeichnet, dass**
der Chip (100) den Halbleiterkörper (4) mit einem zentralen Durchbruch (11) aufweist, in welchem der erste Kontaktbereich (5) angeordnet ist, wodurch die Oberfläche (9) frei von die Strahlung absorbierenden Kontaktstrukturen ist.

2. Chip (100) nach Anspruch 1, wobei
die erste Kontaktschicht (1) auf der Strahlungsaustrittsseite frei ist von die Strahlung absorbierenden Kontaktstrukturen.

3. Chip (100) nach Anspruch 1 oder 2, wobei
der erste Kontaktbereich (5) vom Strahlung emittierenden Bereich räumlich getrennt ist.

4. Chip (100) nach einem der vorhergehenden Ansprüche, wobei
die Oberfläche (9) größtenteils von der ersten Kontaktschicht (5) bedeckt ist.

5. Chip (100) nach einem der vorhergehenden Ansprüche, wobei
- die erste Kontaktschicht (1) eine den Chip (100) in einer Hauptabstrahlrichtung nach außen begrenzende Schicht bildet, und
- die erste Kontaktschicht (5) ein TCO enthält.

6. Chip (100) nach einem der vorhergehenden Ansprüche, wobei
der erste Kontaktbereich (5) ein Bondpad oder Kontaktfinger ist und wobei der erste Kontaktbereich (5) metallisch ausgebildet ist.

7. Chip (100) nach einem der vorhergehenden Ansprüche, wobei
der erste Kontaktbereich (5) und der Halbleiterkörper (4) auf einem gemeinsamen Träger (6) angeordnet sind.

8. Chip (100) nach einem der vorhergehenden Ansprüche, wobei
- der zweite Kontaktbereich (3) auf den Träger (6) aufgebracht ist, und
- der erste Kontaktbereich (5) dem zweiten Kontaktbereich (3) ausgehend vom Träger (6) in vertikaler Richtung nachgeordnet ist.

9. Chip (100) nach einem der vorhergehenden Ansprüche, wobei
- der zweite Kontaktbereich (3) metallisch ausgebildet ist, und
- der zweite Kontaktbereich (3) eine Reflexionsschicht ist.

10. Chip (100) nach Anspruch 9, wobei
die zweite Kontaktschicht (2) zwischen dem Halbleiterkörper (4) und dem zweiten Kontaktbereich (3) angeordnet ist und zusammen mit dem zweiten Kontaktbereich (3) einen Spiegel bildet.

11. Chip (100) nach einem der vorhergehenden Ansprüche, wobei
zwischen dem ersten Kontaktbereich (5) und dem zweiten Kontaktbereich (3) eine Isolierschicht (8) angeordnet ist.

12. Chip (100) nach einem der vorhergehenden Ansprüche,
wobei die zweite Kontaktschicht (2) für die emittierte Strahlung durchlässig ist und ein TCO enthält.

13. Chip (100) nach einem der vorhergehenden Ansprüche, welcher eine Kantenlänge höchstens bis zu 400µm aufweist.

14. Chip (100) nach einem der vorhergehenden Ansprüche,
wobei der den Durchbruch (11) aufweisenden Halbleiterkörper (4) einstückig ausgebildet ist.

15. Chip (100) nach einem der vorhergehenden Ansprüche,
wobei der Durchbruch (11) von einer Isolierschicht (8) ausgekleidet ist und sich die Isolierschicht (8) bis zur Oberfläche (9) des Halbleiterkörpers (4) erstreckt.

## Claims

1. Chip (100)
- comprising at least one semiconductor body (4) having a radiation-emitting region,
- comprising at least one first contact region (5) which is provided for making electrical contact with the semiconductor body (4) and is spaced apart laterally from the radiation-emitting region, and
- comprising an electrically conductive first contact layer (1), which is transmissive to the emitted radiation and which connects a surface (9) of the semiconductor body (4) which is situated on the radiation exit side (10) of the chip (100) to the first contact region (5),
wherein
- the chip (100) has a second contact layer (2), which connects the semiconductor body (4) to a second contact region (3) for making electrical contact with the semiconductor body (4), and
- the semiconductor body (4) is arranged in vertical direction between the first contact layer (1) and second contact layer (2), wherein the vertical direction denotes a direction which runs parallel to a growth direction, in which semiconductor layers of the semiconductor body (4) are grown,
**characterized in that**
- the chip (100) has a semiconductor body (4) with a central perforation (11), in which the first contact region (5) is arranged, so that the surface (9) is free of the radiation-absorbing contact structures.

2. Chip (100) according to claim 1, wherein
the first contact layer (1) on the radiation exit side is free of the radiation-absorbing contact structures.

3. Chip (100) according to claim 1 or 2, wherein
the first contact region (5) is spatially separated from the radiation-emitting region.

4. Chip (100) according to one of the preceding claims, wherein
the surface (9) is covered for the most part by the first contact layer (5).

5. Chip (100) according to one of the preceding claims, wherein
- the first contact layer (1) forms a layer which outwardly delimits the chip (100) in a main emission direction, and
- the first contact layer (5) contains a TCO.

6. Chip (100) according to one of the preceding claims, wherein
the first contact region (5) is a bonding pad or contact finger and wherein the first contact region (5) is formed in metallic fashion.

7. Chip (100) according to one of the preceding claims, wherein
the first contact region (5) and the semiconductor body (4) are arranged on a common carrier (6).

8. Chip (100) according to one of the preceding claims, wherein
- the second contact region (3) is applied to the carrier (6), and
- the first contact region (5) is disposed downstream of the second contact region (3) in a vertical direction proceeding from the carrier (6).

9. Chip (100) according to one of the preceding claims, wherein
- the second contact region (3) is formed in metallic fashion, and
- the second contact region (3) is a reflection layer.

10. Chip (100) according to claim 9, wherein
the second contact layer (2) is arranged between the semiconductor body (4) and the second contact region (3) and together with the second contact region (3) forms a mirror.

11. Chip (100) according to one of the preceding claims, wherein
an insulating layer (8) is arranged between the first contact region (5) and the second contact region (3).

12. Chip (100) according to one of the preceding claims, wherein
the second contact layer (2) is transmissive to the emitted radiation and contains a TCO.

13. Chip (100) according to one of the preceding claims having an edge length of less than 400 µm.

14. Chip (100) according to one of the preceding claims, wherein
the semiconductor body (4) comprising the perforation (11) is formed in one piece.

15. Chip (100) according to one of the preceding claims, wherein
the perforation (11) is lined by the insulating layer (8) and the insulating layer (8) extends as far as the surface (9) of the semiconductor body (4).

## Revendications

1. Puce (100)
- comprenant au moins un corps semi-conducteur (4) qui présente une zone émettrice de rayonnement,
- comprenant au moins une première zone de contact (5) qui est prévue pour la mise en contact électrique du corps semi-conducteur (4) et est distancée latéralement de la zone émettrice de rayonnement, et
- comprenant une première couche de contact (1) électroconductrice, perméable au rayonnement émis, laquelle relie à la première zone de contact (5) une surface (9) du corps semi-conducteur (4), laquelle se trouve sur le côté de sortie du rayonnement (10) de la puce (100),
- la puce (100) présentant une deuxième couche de contact (2) qui relie le corps semi-conducteur (4) à une deuxième zone de contact (3) pour la mise en contact électrique du corps semi-conducteur (4), et
- le corps semi-conducteur (4) étant disposé en direction verticale entre la première couche de contact (1) et la deuxième couche de contact (2), la direction verticale désignant une direction s'étendant parallèlement à une direction de croissance, dans laquelle les couches semiconductrices du corps semi-conducteur (4) ont vu leur croissance,
**caractérisée en ce que**
- la puce (100) présente le corps semi-conducteur (4) avec un passage central (11) dans lequel est disposée la première zone de contact (5), sur quoi la surface (9) est exempte de structures de contact absorbant le rayonnement.

2. Puce (100) selon la revendication 1,
la première couche de contact (1) sur le côté de sortie du rayonnement étant exempte de structures de contact absorbant le rayonnement.

3. Puce (100) selon la revendication 1 ou 2,
la première zone de contact (5) étant spatialement séparée de la zone émettant le rayonnement.

4. Puce (100) selon l'une quelconque des revendications précédentes,
la surface (9) étant en grande partie recouverte par la première couche de contact (5).

5. Puce (100) selon l'une quelconque des revendications précédentes,
- la première couche de contact (1) formant une couche délimitant vers l'extérieur la puce (100) dans une direction principale de rayonnement, et
- la première couche de contact (5) contenant un oxyde conducteur transparent (TCO).

6. Puce (100) selon l'une quelconque des revendications précédentes,
la première zone de contact (5) étant un plot de connexion ou un doigt de contact, et la première zone de contact (5) étant réalisée de manière métallique.

7. Puce (100) selon l'une quelconque des revendications précédentes,
la première zone de contact (5) et le corps semi-conducteur (4) étant disposés sur un support commun (6).

8. Puce (100) selon l'une quelconque des revendications précédentes,
- la deuxième zone de contact (3) étant appliquée sur le support (6), et
- la première zone de contact (5), en partant de la deuxième zone de contact (3), étant disposée en aval du support (6) en direction verticale.

9. Puce (100) selon l'une quelconque des revendications précédentes,
- la deuxième zone de contact (3) étant réalisée de manière métallique, et
- la deuxième zone de contact (3) étant une couche réfléchissante.

10. Puce (100) selon la revendication 9,
la deuxième couche de contact (2) étant disposée entre le corps semi-conducteur (4) et la deuxième zone de contact (3) et formant un miroir avec la deuxième zone de contact (3) .

11. Puce (100) selon l'une quelconque des revendications précédentes,
une couche d'isolation (8) étant disposée entre la première zone de contact (5) et la deuxième zone de contact (3).

12. Puce (100) selon l'une quelconque des revendications précédentes,
la deuxième couche de contact (2) étant perméable au rayonnement émis et contenant un oxyde conducteur transparent (TCO).

13. Puce (100) selon l'une quelconque des revendications précédentes,
laquelle présente une longueur d'arête de maximum jusqu'à 400 µm.

14. Puce (100) selon l'une quelconque des revendications précédentes,
le corps semi-conducteur (4) présentant le passage (11) étant réalisé d'une seule pièce.

15. Puce (100) selon l'une quelconque des revendications précédentes,
le passage (11) étant recouvert d'une couche d'isolation (8) et la couche d'isolation (8) s'étendant jusqu'à la surface (9) du corps semi-conducteur (4).
